# EUROPÄISCHE PATENTSCHRIFT

(11) **EP 1 099 223 B1**
(45) Veröffentlichungstag und Bekanntmachung des Hinweises auf die Patenterteilung: **23.10.2002**
(21) Anmeldenummer: 99945859.9
(22) Anmeldetag: 01.07.1999
(51) Int. Cl.: G11C 11/22

(54) **SPEICHERANORDNUNG AUS EINER VIELZAHL VON RESISTIVEN FERROELEKTRISCHEN SPEICHERZELLEN**
STORAGE ASSEMBLY COMPRISED OF A PLURALITY OF RESISTIVE FERROELECTRIC STORAGE CELLS
ENSEMBLE MEMOIRE CONSTITUE D'UNE PLURALITE DE CELLULES DE MEMOIRE RESISTIVES FERROELECTRIQUES

(30) Priorität: 22.07.1998 DE 19832991
(43) Veröffentlichungstag der Anmeldung: 16.05.2001
(73) Patentinhaber: Infineon Technologies AG, 81669 München (DE)
(72) Erfinder: KOWARIK, Oskar, D-85579 Neubiberg (DE); HOFFMANN, Kurt, D-82024 Taufkirchen (DE)
(74) Vertreter: Kottmann, Heinz Dieter, Dipl.-Ing.
(86) Internationale Anmeldenummer: DE9902003
(87) Internationale Veröffentlichungsnummer: WO00005719

(56) Entgegenhaltungen:
- EP-A- 0 167 143
- WO-A-99/14761

## Beschreibung

Die vorliegende Erfindung betrifft eine Speicheranordnung aus einer Vielzahl von resistiven ferroelektrischen Speicherzellen nach dem Oberbegriff des Patentanspruchs 1.

Ferroelektrische Speicheranordnungen, bei denen die Zellplattenspannung fest auf die halbe Versorgungsspannung (Vcc/2) der Speicheranordnung gelegt ist, zeichnen sich durch schnelle Speicheroperationen aus. Allerdings tritt bei diesen Speicheranordnungen das Problem eines möglichen Verlustes der in den Speicherkondensatoren gespeicherten Daten auf: da die Zellknoten an den Speicherkondensatoren floatend sind, solange die Auswahltransistoren sperren, und diese Zellknoten parasitäre pn-Übergänge zum Halbleitersubstrat bilden, verursachen zwangsläufig auftretende Leckströme über diese pn-Übergänge ein Absinken der Zellknotenspannung auf Massespannung Vss. Die anderen Knoten der ferroelektrischen Speicherkondensatoren bleiben dabei auf der festen Zellplattenspannung Vcc/2 liegen. Dadurch kann der Inhalt der ferroelektrischen Speicherkondensatoren durch Umprogrammieren zerstört werden.

Um diesen Datenverlust zu vermeiden, wird ähnlich wie bei DRAMs ein Refresh der Speicherzellen vorgenommen, bevor deren Inhalt zerstört ist. Der Refresh erfolgt dadurch, daß die Bitleitungen der Speicheranordnung auf die halbe Versorgungsspannung Vcc/2 vorgeladen werden und die Zellknoten durch Aktivierung der Wortleitungen ebenfalls auf die halbe Versorgungsspannung Vcc/2 aufgeladen werden, so daß über den Speicherkondensatoren 0 V abfallen.

Ein solcher Refresh ist aufwendig und erfordert zusätzliche Operationen, die möglichst vermieden werden sollten.

In der US 5 121 353 A wird eine Speicheranordnung mit ferroelektrischen Speicherzellen beschrieben, die statisch arbeitet und auf einen Refresh verzichten kann. Hierzu müssen aber jedem Speicherkondensator zwei Auswahltransistoren zugeordnet werden, die jeweils an verschiedene Wortleitungen anzuschließen sind, was diese bekannte Speicheranordnung aufwendig macht.

Es ist daher Aufgabe der vorliegenden Erfindung, eine einfach aufgebaute Speicheranordnung aus einer Vielzahl von resistiven, ferroelektrischen Speicherzellen zu schaffen, die jeweils so gestaltet sind, daß ein Leckstrom am Zellknoten nicht mehr ein Umprogrammieren der jeweiligen Speicherzellen verursachen kann, so daß auf einen Refresh der Speicherzellen verzichtet werden kann.

Diese Aufgabe wird bei einer Speicheranordnung nach dem Oberbegriff des Patentanspruches 1 erfindungsgemäß durch die in dessen kennzeichnendem Teil enthaltenen Merkmale gelöst.

Bei der erfindungsgemäßen Speicheranordnung werden so die beiden Elektroden des Speicherkondensators, also die sogenannten Kapazitätsknoten, über einen Widerstand und eine durch den MOS-Transistor gebildete Verbindungsleitung miteinander verbunden. Die Verbindungsleitung aus dem MOS-Transistor mit großer Kanallänge wird auf der Zellplattenspannung gehalten.

Der Widerstand ist so zu bemessen, daß sein Widerstandswert wesentlich kleiner ist als der Widerstandswert des durch den pn-Übergang gebildeten Sperrwiderstandes des Auswahltransistors zwischen dessen Drain bzw. Source und dem Halbleitersubstrat, wobei der Lese- und Schreibvorgang durch diesen Widerstand nur äußerst geringfügig beeinflußt werden sollte.

Hierdurch wird sichergestellt, daß einerseits der Lese- und Schreibvorgang durch den Widerstand nahezu ungestört ist und andererseits der Leckstrom des parasitären pn-Überganges zum Halbleitersubstrat durch den Widerstand kompensiert wird, so daß an beiden Kapazitätsknoten des ferroelektrischen Speicherkondensators annähernd die Zellplattenspannung anliegt. Ein ungewolltes Umprogrammieren des Speicherkondensators kann damit nicht mehr erfolgen, so daß auf einen Refresh verzichtet werden kann.

An der Erfindung ist somit wesentlich, daß das Ende bzw. der Knoten des Widerstandes, das bzw. der mit der Elektrode des Speicherkondensators zu verbinden ist, die auf der festen Zellplattenspannung liegt, über einen MOS-Transistor, dessen Kanallänge sich über mehrere Speicherzellen erstreckt, auf der Zellplattenspannung gehalten wird. So liegen beispielsweise 20 bis 100 Speicherzellen über das Drain- und Source-Gebiet dieses MOS-Transistors über einen Kontakt und eine beispielsweise aus Aluminium bestehende Leitung auf der Zellplattenspannung.

Es gibt nun zwei Ausführungsvarianten für die Gestaltung des Widerstandes und der Verbindungsleitung aus dem MOS-Transistor:

Bei der ersten Variante wird der Widerstand durch eine geeignete Dotierung unter dem Dickoxid neben dem Auswahltransistor realisiert, wobei ein Ende dieses Widerstandes über den MOS-Transistor mit großer Kanallänge auf der Zellplattenspannung gehalten wird und am MOS-Transistor eine Gatespannung VZ anliegt, während Drain und Source dieses MOS-Transistors mit der Zellplattenspannung beaufschlagt sind. Die Gatespannung VZ wird dabei so eingestellt, daß sich die Zellplattenspannung über den gesamten Kanal des MOS-Transistors erstreckt.

Bei der zweiten Variante wird sowohl der Widerstand an jeder Speicherzelle als auch die Zuführung der Zellplattenspannung über den MOS-Transistor mit großer Kanallänge realisiert, wobei - wie bei der ersten Variante - an Drain und Source dieses MOS-Transistors die Zellplattenspannung anliegt. Gate des MOS-Transistors ist mit einer Spannung VS beaufschlagt, die konstant auf einem Wert gehalten ist, so daß sich entweder zu jeder Speicherzelle ein Strom ergibt, der den eingangs genannten Bedingungen für den Widerstand in bezug auf den Sperrwiderstandswert des pn-Überganges und den Lese- und Schreibvorgang entspricht und das entsprechende Ende des Widerstandes (Widerstandsknoten) auf die Zellplattenspannung zieht, oder sich zu jeder Zelle ein Strom ergibt, der diesen Bedingungen für den Widerstand entspricht und zusätzlich nach jedem Lese- und/oder Schreibvorgang sowie beim Anlegen und Abschalten der Versorgungsspannung für die Speicheranordnung die Gatespannung VS auf einen Wert bringt, damit die einzelnen Elektroden des Speicherkondensators in den jeweiligen Speicherzellen schnell auf die Zellplattenspannung gezogen werden. Vorteilhaft an dieser zuletzt genannten Methode ist, daß die Elektroden des Speicherkondensators sofort auf die Zellplattenspannung gebracht werden. Dabei können alle MOS-Transistoren mit großer Kanallänge jeweils geschaltet werden; es ist aber auch möglich, nur diejenigen MOS-Transistoren mit großer Kanallänge zu schalten, die zu der jeweiligen Bitleitung gehören und mit einem Bitleitungsdecodierer ausgewählt sind.

Bei der erfindungsgemäßen Speicheranordnung ist ein unbeabsichtigtes Umprogrammieren durch den Leckstrom des parasitären pn-Überganges zum Substrat ausgeschlossen, so daß ein Refresh nicht erforderlich ist. Es ist möglich, normale Wortleitungsdecodierer einzusetzen. Auch wird die Kapazität der Wortleitung nicht vergrößert. Beim Abschalten der Versorgungsspannung ist eine unbeabsichtigte Umprogrammierung ebenfalls ausgeschlossen. Zwischen beispielsweise einem n⁺-leitenden Gebiet am Widerstand und der Elektrode des Speicherkondensators, die auf der festen Zellplattenspannung liegt, ist kein Plug ("Stöpsel") erforderlich, was die Anforderungen an die Technologie bei der Herstellung der Speicheranordnung absenkt, da kein zusätzliches Kontaktloch für diesen Plug benötigt wird. Auch kann dadurch Platz auf dem Halbleitersubstrat eingespart werden. Mit anderen Worten, die Speicherzellenfläche ist bei der erfindungsgemäßen Speicheranordnung gegenüber einer Standardzelle nicht vergrößert. Schließlich sind auch keine zusätzlichen Technologie- und Prozeßschritte erforderlich, um die erfindungsgemäße Speicheranordnung zu realisieren.

Nachfolgend wird die Erfindung anhand der Zeichnungen näher erläutert. Es zeigen:
- Fig. 1: ein Schaltbild der erfindungsgemäßen Speicheranordnung,
- Fig. 2: eine schematische Schnittdarstellung durch ein erstes Ausführungsbeispiel der erfindungsgemäßen Speicheranordnung,
- Fig. 3: eine schematische Draufsicht auf das Ausführungsbeispiel von Fig. 2,
- Fig. 4: eine schematische Schnittdarstellung eines zweiten Ausführungsbeispiels der erfindungsgemäßen Speicheranordnung und
- Fig. 5: eine Draufsicht auf die Speicheranordnung von Fig. 4.

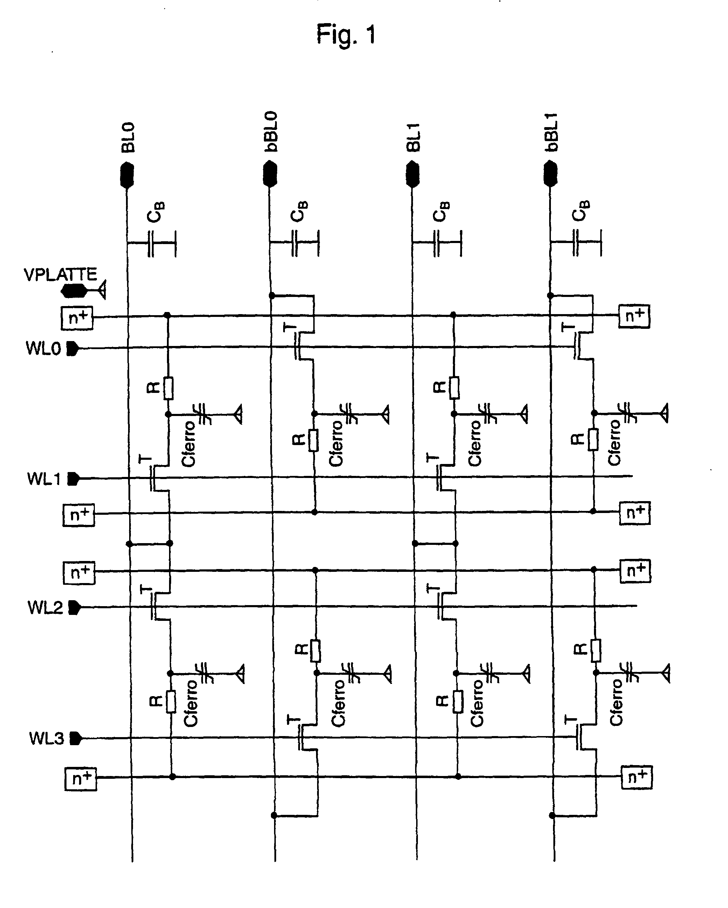

Fig. 1 zeigt ein Speicherzellenfeld in gefalteter Bitleitungsarchitektur, wobei speziell die Verbindung der Elektroden des Speicherkondensators, der sogenannten Kapazitätsknoten, über einen geeigneten Widerstand und eine auf Zellplattenspannung liegende Verbindungsleitung, die durch einen MOS-Transistor mit langem Kanal realisiert ist, dargestellt ist. Diese Verbindung der Kapazitätsknoten kann selbstverständlich gegebenenfalls auch bei einer sogenannten offenen Bitleitungsarchitektur angewandt werden.

Im einzelnen sind in Fig. 1 Wortleitungen WL0, WL1, WL2 und WL3 sowie Kapazitäten C_{B} aufweisende Bitleitungen BL0, bBL0, BL1 und bBL1 für Eintransistor-Einkondensator-(1T1C-)Speicherzellen aus Auswahltransistoren T und ferroelektrischen Speicherkondensatoren Cferro dargestellt.

An den einen Elektroden der Speicherkondensatoren Cferro liegt eine feste Zellplattenspannung, die über eine Verbindungsleitung aus einem MOS-Transistor mit Source- bzw. Drain-Gebieten n⁺ und einen Widerstand R auch den anderen Elektroden der Speicherkondensatoren zugeführt ist. Das heißt, die beiden Kapazitätsknoten sind über den Widerstand R und die Verbindungsleitung aus dem MOS-Transistor miteinander verbunden. In der Fig. 1 sind diese MOS-Transistoren durch ihre Source- bzw. Drain-Gebiete n⁺ schematisch angedeutet, wobei der Kanal mit großer Kanallänge zwischen diesen Gebieten n⁺ geführt ist und an der (nicht gezeigten) Gateelektrode zwischen diesen Gebieten n⁻ eine Gatespannung VZ (erstes Ausführungsbeispiel) bzw. VS (zweites Ausführungsbeispiel) anliegt. Die Verbindungsleitung wird also auf der Zellplattenspannung VPLATTE gehalten.

Der Widerstand R ist so beschaffen, daß
(a) sein Widerstandswert wesentlich kleiner als der Widerstandswert des Sperrwiderstandes des pn-Überganges zum Halbleitersubstrat ist und
(b) der Lese- und Schreibvorgang durch den Widerstand R nur äußerst geringfügig beeinflußt wird.

Dadurch ist sichergestellt, daß der Lese- und Schreibvorgang durch den Widerstand R nahezu ungestört bleibt und der Leckstrom des parasitären pn-Überganges durch den Widerstand R kompensiert wird, so daß an beiden Seiten der ferroelektrischen Speicherkondensatoren Cferro annähernd die Zellplattenspannung VPLATTE anliegt. Ein ungewolltes Umprogrammieren der Speicherkondensatoren Cferro kann damit nicht mehr erfolgen.

Der mit der Zellplattenspannung VPLATTE zu verbindende Anschluß bzw. Knoten des Widerstandes R ist so jeweils über den MOS-Transistor (Gebiete n⁺) mit langem Kanal auf der Zellplattenspannung VPLATTE gehalten. Dieser lange Kanal kann sich über mehrere Speicherzellen, beispielsweise 20 bis 100 Speicherzellen, erstrecken. Bei beispielsweise allen 20 bis 100 Speicherzellen wird so das Drain- bzw. Sourcegebiet n⁺ des MOS-Transistors über einen Kontakt und eine beispielsweise aus Aluminium bestehende Leitung auf der Zellplattenspannung VPLATTE gehalten.

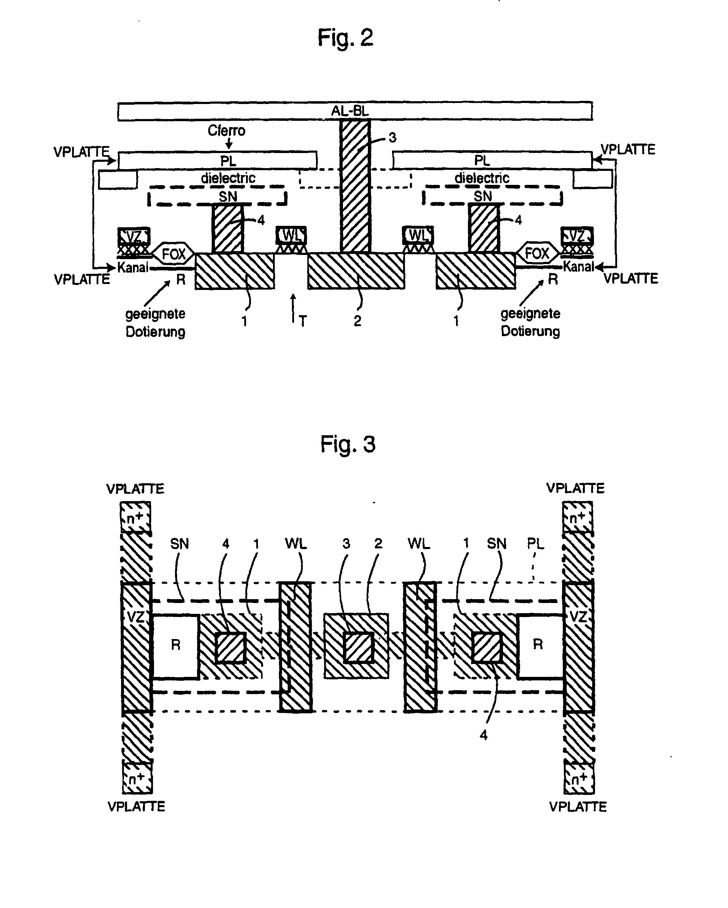

Fig. 2 zeigt nun ein schematisches Schnittbild durch ein erstes Ausführungsbeispiel der Erfindung, dessen Draufsicht in Fig. 3 dargestellt ist.

In Fig. 2 sind Drain-Gebiete 1, die beispielsweise n⁺-dotiert sind, und ein Sourcegebiet 2, das beispielsweise ebenfalls n⁺-dotiert ist, in der Oberfläche eines p-leitenden Halbleiterkörpers vorgesehen. Das Source-Gebiet 2 ist durch einen Kontakt-Plug 3 aus beispielsweise polykristallinem Silizium, der durch eine nicht näher gezeigte Isolierschicht aus beispielsweise Siliziumdioxid führt, mit einer aus beispielsweise Aluminium bestehenden Bitleitung AL-BL verbunden.

Oberhalb des Kanales zwischen den Drain- und Source-Gebieten 1 bzw. 2 sind Wortleitungen WL in die Isolierschicht eingebettet. Die Drain-Gebiete 1 sind über Plugs (Stöpsel) 4 aus beispielsweise polykristallinem Silizium mit Speicherknoten SN von Speicherkondensatoren verbunden. Diese Speicherkondensatoren bestehen aus den Speicherknoten SN, einem ferroelektrischen Dielektrikum dielectric und gemeinsamen Speicherknoten PL (vgl. die die beiden Speicherknoten PL verbindenden Strichlinien in Fig. 2), an denen die Zellplattenspannung VPLATTE anliegt.

Der Widerstand R wird durch eine geeignete Dotierung unter dem Dickoxid FOX realisiert, wobei ein Ende bzw. Knoten des Widerstandes R an das Drain-Gebiet 1 angeschlossen ist und das andere Ende des Widerstandes R zu dem MOS-Transistor mit großer Kanallänge führt, an dessen Gate eine Gate-Spannung VZ anliegt. Dieser MOS-Transistor ist mit seinem Gate ("VZ") und dem Wort "Kanal" in der Fig. 2 schematisch angedeutet. Er liegt zwischen dem dem Drain-Gebiet 1 abgewandten Ende des Widerstandes R und dem Speicherknoten PL. Die n⁺-Gebiete (Drain bzw. Source) des MOS-Transistors sind mit der Zellplattenspannung VPLATTE beaufschlagt (vgl. Fig. 3). Die Gate-Spannung VZ des MOS-Transistors mit großer Kanallänge wird so eingestellt, daß sich die Zellplattenspannung VPLATTE über den gesamten Kanal erstreckt.

Das Ausführungsbeispiel der Fig. 2 und 3 sieht eine offene Bitleitungsstruktur vor. Selbstverständlich kann die Erfindung aber auch auf eine gefaltete Bitleitungsstruktur angewandt werden.

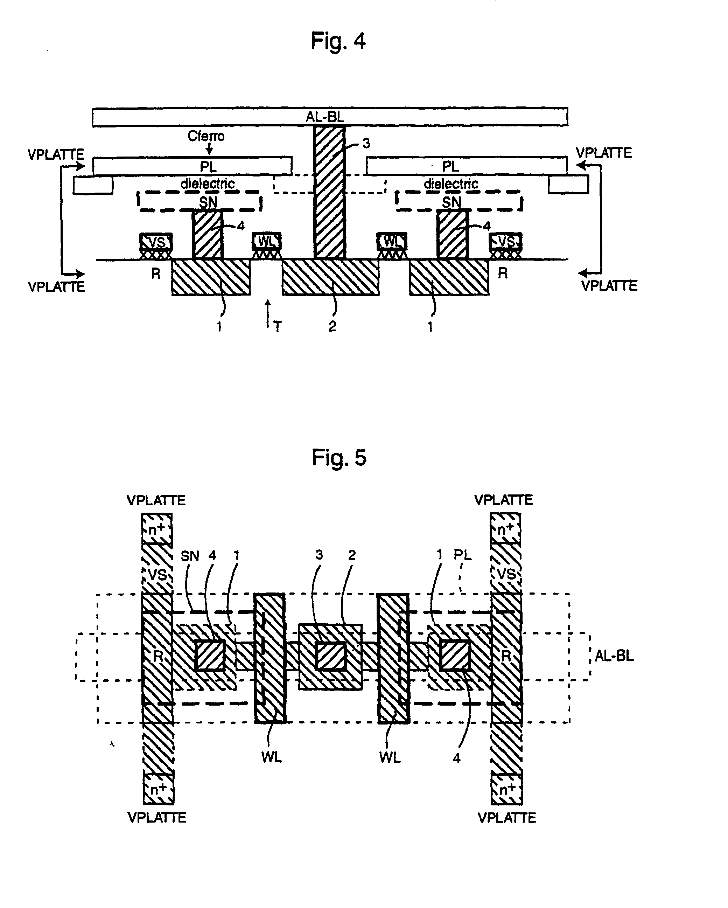

Die Fig. 4 und 5 zeigen ein zweites Ausführungsbeispiel der Erfindung, wobei Fig. 4 eine schematische Schnittdarstellung ist und Fig. 5 eine Draufsicht darstellt. In den Fig. 4 und 5 werden für einander entsprechende Bauteile die gleichen Bezugszeichen wie in den Fig. 2 und 3 verwendet.

Beim Ausführungsbeispiel der Fig. 4 und 5 wird der Widerstand R an jeder Zelle und die Zuführung der Zellplattenspannung VPLATTE über dem MOS-Transistor (n⁺) mit langem Kanal realisiert, wobei an Drain- bzw. Source-Gebiet (vgl. Bezugszeichen "n⁺") des MOS-Transistors die Zellplattenspannung VPLATTE anliegt. An Gate des MOS-Transistors liegt die Spannung VS an, die entweder
(a) konstant auf einem Wert gehalten wird, so daß sich zu jeder Speicherzelle ein Strom ergibt, der den oben genannten Bedingungen für den Widerstand R entspricht und das dem Drain-Gebiet 1 abgewandte Ende des Widerstandes R auf der Zellplattenspannung VPLATTE hält, oder
(b) konstant auf einem Wert gehalten wird, so daß sich zu jeder Speicherzelle ein Strom ergibt, der den oben genannten Bedingungen für den Widerstand R entspricht und zusätzlich nach jedem Lese- und/oder Schreibvorgang sowie beim Anlegen und Abschalten der Versorgungsspannung an der Speicheranordnung die Gatespannung VS des MOS-Transistors auf einen Wert gebracht wird, damit die einzelnen Speicherknoten in den Speicherzellen schnell auf die Zellplattenspannung VPLATTE gezogen werden.

Speziell mit dem zuletzt genannten Verfahren können die Speicherknoten sofort auf die Zellplattenspannung VPLATTE gebracht werden. Es können jeweils alle MOS-Transistoren mit langem Kanal oder aber nur die zur jeweiligen Bitleitung gehörigen, mit einem Bitleitungsdecodierer ausgewählten MOS-Transistoren mit langem Kanal geschaltet werden.

## Patentansprüche

1. Speicheranordnung aus einer Vielzahl von resistiven ferroelektrischen Speicherzellen aus jeweils einem Auswahltransistor (T) und einem Speicherkondensator (Cferro), dessen eine Elektrode (PL) auf einer festen Zellplattenspannung (VPLATTE) liegt und dessen andere Elektrode (SN) mit einer einen ersten Leitungstyp aufweisenden ersten Zone (1) des Auswahltransistors verbunden ist, wobei der Auswahltransistor (T) und der Speicherkondensator (Cferro) in bzw. auf einem Halbleitersubstrat eines zweiten, zum ersten Leitungstyp entgegengesetzten Leitungstyps vorgesehen sind,
**dadurch gekennzeichnet, dass**
die mit dem Speicherkondensator (Cferro) verbundene Zone (1) des Auswahltransistors (T) über einen Widerstand (R) an ein Ende des Kanals eines MOS-Transistors (n⁺) angeschlossen ist, dessen Kanallänge sich über wenigstens zwei Speicherzellen erstreckt und an dessen anderem Ende die feste Zellplattenspannung (VPLATTE) anliegt, sodass die mit dem Speicherkondensator (Cferro) verbundene Zone (1) über den Widerstand (R) und den MOS-Transistor (n⁺) mit der einen Elektrode (PL) des Speicherkondensators (Cferro) elektrisch verbunden ist.

2. Speicheranordnung nach Anspruch 1,
**dadurch gekennzeichnet,**
**daß** der Widerstand (R) durch entsprechende Dotierung im Halbleiterkörper festgelegt ist, und daß die Gatespannung des MOS-Transistors derart einstellbar ist, daß die feste Zellplattenspannung (VPLATTE) über dem gesamten Kanal des MOS-Transistors anlegbar ist.

3. Speicheranordnung nach Anspruch 1,
**dadurch gekennzeichnet,**
**daß** an Drain und Source des MOS-Transistors die feste Zellplattenspannung (VPLATTE) anliegt und das Gate des MOS-Transistors mit einer Spannung (VS) beaufschlagt ist, die bewirkt, daß der Strom zu jeder Speicherzelle den Leckstrom des parasitären pn-Überganges zum Halbleitersubstrat kompensiert.

4. Speicheranordnung nach einem der Ansprüche 1 bis 3,
**dadurch gekennzeichnet,**
**daß** sich der MOS-Transistor mit seinem Kanal über mehrere Speicherzellen erstreckt.

5. Speicheranordnung nach Anspruch 4,
**dadurch gekennzeichnet,**
**daß** sich der Kanal des MOS-Transistors über 20 bis 100 Speicherzellen erstreckt.

6. Speicheranordnung nach einem der Ansprüche 1 bis 5,
**dadurch gekennzeichnet,**
**daß** Drain und Source des MOS-Transistors den gleichen Leitungstyp wie Drain (1) und Source (2) des Auswahltransistors (T) haben.

7. Speicheranordnung nach einem der Ansprüche 1 bis 6,
**dadurch gekennzeichnet,**
**daß** die Drain (1) des Auswahltransistors (T) mit der anderen Elektrode (SN) des Speicherkondensators (Cferro) durch einen Plug (4) verbunden ist.

8. Speicheranordnung nach einem der Ansprüche 1 bis 7,
**dadurch gekennzeichnet,**
**daß** die Source (2) des Auswahltransistors (T) durch einen Plug (3) mit einer Bitleitung (AL-BL) verbunden ist.

## Claims

1. Memory arrangement comprising a multiplicity of resistive ferroelectric memory cells each comprising a selection transistor (T) and a storage capacitor (Cferro), one electrode (PL) of which is at a fixed cell plate voltage (VPLATE) and the other electrode (SN) of which is connected to a zone (1) of the selection transistor, said zone having a first conduction type, the selection transistor (T) and the storage capacitor (Cferro) respectively being provided in and on a semiconductor substrate of a second conduction type, which is opposite to the first conduction type,
**characterized**
**in that** the zone (1) of the selection transistor (T) which is connected to the storage capaciter (Cferro) is connected via a resistor (R) to one end of the channel of a MOS transistor (n⁺) whose channel length extends over at least two memory cells and to whose other end the fixed cell plate voltage (VPLATE) is applied, so that the zone (1) connected to the storage capacitor (Cferro) is electrically connected to one electrode (PL) of the storage capacitor (Cferro) via the resistor (R) and the MOS transistor (n⁺).

2. Memory arrangement according to Claim 1,
**characterized**
**in that** the resistor (R) is defined by corresponding doping in the semiconductor body, and in that the gate voltage of the MOS transistor can be set in such a way that the fixed cell plate voltage (VPLATE) can be applied across the entire channel of the MOS transistor.

3. Memory arrangement according to Claim 1,
**characterized**
**in that** the fixed cell plate voltage (VPLATE) is applied to the drain and source of the MOS transistor and a voltage (VS) is applied to the gate of the MOS transistor, the effect of which voltage (VS) is that the current to each memory cell compensates for the leakage current of the parasitic pn junction to the semiconductor substrate.

4. Memory arrangement according to one of Claims 1 to 3,
**characterized**
**in that** the MOS transistor extends over a
plurality of memory cells with its channel.

5. Memory arrangement according to Claim 4,
**characterized**
**in that** the channel of the MOS transistor extends over 20 to 100 memory cells.

6. Memory arrangement according to one of Claims 1 to 5,
**characterized**
**in that** the drain and source of the MOS transistor have the same conduction type as the drain (1) and source (2) of the selection transistor (T).

7. Memory arrangement according to one of Claims 1 to 6,
**characterized**
**in that** the drain (1) of the selection transistor (T) is connected to the other electrode (SN) of the storage capacitor (Cferro) by a plug (4).

8. Memory arrangement according to one of Claims 1 to 7,
**characterized**
**in that** the source (2) of the selection transistor (T) is connected to a bit line (AL-BL) by a plug (3).

## Revendications

1. Dispositif de mémoire constitué d'une pluralité de cellules de mémoire résistives, ferroélectriques, se composant respectivement d'un transistor (T) de sélection et d'un condensateur (Cferro) de mémoire, sur l'une des électrodes (PL) duquel est appliquée une tension (VPLATTE) fixe de plaque de cellule et dont l'autre électrode (SN) est reliée à une première zone
(1) du transistor de sélection ayant un premier type de conductivité, le transistor (T) de sélection et le condensateur (Cferro) de mémoire étant prévus dans ou sur un substrat semi-conducteur d'un deuxième type de conductivité opposé au premier type de conductivité, **caractérisé en ce que** la zone (1) reliée au condensateur (Cferro) de mémoire du transistor (T) de sélection est raccordée par une résistance (R) à une extrémité du canal d'un transistor (n⁺) MOS dont la longueur du canal s'étend sur au moins deux cellules de mémoire et à l'autre extrémité duquel est appliquée la tension (VPLATTE) fixe de plaque de cellule, de sorte que la zone (1) reliée au condensateur (Cferro) de mémoire est reliée électriquement par la résistance (R) et par le transistor (n⁺) MOS à ladite une des électrodes (PL) du condensateur (Cferro) de mémoire.

2. Dispositif de mémoire suivant la revendication 1, **caractérisé en ce que** la résistance (R) est fixée par un dopage adéquat du corps semi-conducteur et **en ce que** la tension de grille du transistor MOS peut être réglée de façon à ce que la tension (VPLATTE) fixe de plaque de cellule puisse être appliquée sur tout le canal du transistor MOS.

3. Dispositif de mémoire suivant la revendication 1, **caractérisé en ce qu'**il s'applique sur le drain et la source du transistor MOS la tension (VPLATTE) fixe de la plaque de cellule et **en ce qu'**il s'applique à la grille du transistor MOS une tension (VS) qui fait que le courant allant à chaque cellule de mémoire compense le courant de fuite de la jonction (pn) parasite vis-à-vis du substrat semi-conducteur.

4. Dispositif de mémoire suivant l'une des revendications 1 à 3, **caractérisé en ce que** le transistor MOS s'étend par son canal sur plusieurs cellules de mémoire.

5. Dispositif de mémoire suivant la revendication 4, **caractérisé en ce que** le canal du transistor MOS s'étend sur 20 à 100 cellules de mémoire.

6. Dispositif de mémoire suivant l'une des revendications 1 à 5, **caractérisé en ce que** le drain et la source du transistor MOS ont le même type de conductivité que le drain (1) et la source (2) du transistor (T) de sélection.

7. Dispositif de mémoire suivant l'une des revendications 1 à 6, **caractérisé en ce que** le drain (1) du transistor (T) de sélection est relié à l'autre électrode (SN) du condensateur (Cferro) de mémoire par un tampon (4).

8. Dispositif de mémoire suivant l'une des revendications 1 à 7, **caractérisé en ce que** la source (2) du transistor (T) de sélection est reliée par un tampon (3) à une ligne (AL-BL) de bits.
